# EUROPÄISCHE PATENTSCHRIFT

(11) **EP 1 494 274 B1**
(45) Veröffentlichungstag und Bekanntmachung des Hinweises auf die Patenterteilung: **12.08.2015**
(21) Anmeldenummer: 04090232.2
(22) Anmeldetag: 14.06.2004
(51) Int. Cl.: H01L 21/331, H01L 21/3213

(54) **Verfahren zur Herstellung von InP-basierten Heterostruktur-Bipolartransistoren auf der Grundlage von III/V-Halbleitern**
Method for manufacturing heterostructure bipolar InP-transistors based on III-V semiconductors
Méthode de fabrication de transistors InP bipolaires à hétérostructure à base de matériaux semi-conducteurs III-V

(30) Priorität: 01.07.2003 DE 10330359
(43) Veröffentlichungstag der Anmeldung: 05.01.2005
(73) Patentinhaber: Forschungsverbund Berlin e.V., 12489 Berlin (DE)
(72) Erfinder: Kim, Seon-Ohk, 50939 Köln (DE); Würfl, Joachim, 15738 Zeuthen (DE); Wittrich, Harald, 13129 Berlin (DE)
(74) Vertreter: Gulde & Partner

(56) Entgegenhaltungen:
- US-A- 5 434 091
- US-A1- 2002 117 685
- US-A1- 2002 153 534
- US-A1- 2003 045 112
- KÖNIG HARALD ET AL.: "Highly resolved maskless patterning on InP by focused ion beam enhanced wet chemical cleaning" JAPANESE JOURNAL OF APPLIED PHYSICS, Bd. 38, Nr. 10, Oktober 1999 (1999-10), Seiten 6142-6144, XP008058637

## Beschreibung

Die Erfindung betrifft ein Verfahren zur Herstellung von InP-basierten Heterostruktur-Bipolartransistoren auf der Grundlage von III/V-Halbleitern.

Zur Herstellung von Heterostruktur-Bipolartransistoren (HBT) werden bisher nasschemische Ätzverfahren benutzt die zu Ätzprofilen führen, deren geometrische Eigenschaften von der Zusammensetzung und Schichtdicke der strukturierten Epitaxieschichten und von den Eigenschaften der zum Ätzen verwendeten Chemikalien abhängig sind. Generell lassen sich die resultierenden Geometrien in lateraler Richtung (parallel zur Oberfläche) nur sehr schwer bezüglich der Homogenität über den Wafer und der Reproduzierbarkeit von Wafer zu Wafer kontrollieren. Zudem beobachtet man ein stark anisotropes, das heißt von der Kristallorientierung abhängiges Ätzverhalten.

Von Matsuoka et al., Ultrahigh-Speed InP/InGaAs Double-Heterostructure Bipolar Transistors and Analyses of Their Operation, Jpn. J. Appl. Phys. Vol. 35 (1996), S. 5646 - 5654 wurde dazu vorgeschlagen, den Emitter hexagonal zu formen. Die Emitter müssen dabei streng in der Kristallorientierung [011] bzw. [0-1-1] ausgerichtet werden. Die dazu im Winkel von 45° stehenden Seiten sind dann parallel zur [010]- und [001]-Orientierung ausgerichtet. Die Ausrichtung parallel zur [01-1]- bzw. [0-11]-Orientierung wird so vermieden. Der Ätzprozess kann mit einer solchen Anordnung etwas besser kontrolliert werden, so dass einerseits Kurzschlüsse zwischen Basis und Emitter vermieden werden und andererseits keine unerwünscht hohen Unterätzungen auftreten.

Eine parallel zur [01-1]-, [0-11]-Orientierung gerichtete Seite wird auch vermieden, wenn der Emitter mit seinen Seiten parallel zu den Kristallorientierungen [010] und [001] ausgerichtet wird. über entsprechende Untersuchungen haben Matine et al., InP In HBTs by Vertical and Lateral Wet Etching, Tagung Indium Phosphide and Related Materials 1998 berichtet.

Beide Methoden sind heute Standard. Bei der Transistorfertigung kann ein Wafer nur in seiner Hauptspaltrichtung gespalten werden. Die Transistorstrukturen müssten allerdings um 45° gedreht prozessiert werden, um mit einer höheren Ätzrate arbeiten zu können und um die Stege herstellen zu können.

Heterostruktur-Bipolartransistoren im Höchstfrequenzbereich haben sehr geringe Emitterabmessungen und benötigen eine separate Basis-Dummymesa. Es ist bekannt, die Verbindung der Basismetallisierung mit dem Basisanschluss durch eine unterätzte Brücke zu realisieren. Die Unterätzung erfordert ein Ätzen in lateraler Richtung. Damit hier ebenfalls die [01-1]- bzw. [0-11]-Richtung ausgeschlossen wird, wurde von Ida et al., High Performance Small InP/InGaAs HBTs with Reduced Parasitic Base-collector Capacitance Fabricated Using a Novel Base-metal Design, Tagungsmaterial International Symposium on Compound Semiconductors 1999, We, A 2.1 vorgeschlagen, auch die Brücke im Winkel von 45° zur Emitterlängsrichtung ([001]- bzw. [0-10]-Orientierung) verlaufen zu lassen. Zur Reduktion von parasitären Kapazitäten im Bereich der Basis/Kollektor-Mesa wird außerdem die Basismetallisierung gezielt unterätzt, siehe neben der letztgenannten Literaturstelle auch Matine et al., Fabrication and Characterization of InP Hetrojunction Bipolar Transistors with Emitter Edges parallel to [001] and [010] Crystal Orientation, Jpn. J. Appl. Phys. Vol. 38 (1999), S. 1200 - 1203. Die um 45° gedrehten Stege bedeuten allerdings eine Vergeudung der wertvollen Fläche des Wafers.

Es verbleibt das Problem, dass in mindestens zwei Richtungen der Kristallorientierung geätzt werden muss, was wegen der unterschiedlichen Ätzraten zu verschieden starkem Unterätzen führt. Außerdem besteht bei bestimmten Halbleitern, so bei InP, das Problem, dass in den Kristallrichtungen [001], [010], [00-1], [0-10] die Ätzrate abhängig ist von den Ätzrichtungen. Das Ätzen führt dort deshalb zu parallelogrammförmigen Strukturen. Alles in allem sind also die Geometrien in lateraler Ätzrichtung noch nicht in befriedigender Weise kontrollierbar.

US 2002/117685 A1 beschreibt ein Verfahren zur Herstellung eines HBT bei dem in den Emitter und in den Sub-Emitter mit Bor-Ionen implantiert werden, um aus der n-dotierten InAlAs Emitterschicht eine extrinsische InAlAs Emitterschicht mit hohem Widerstand und aus der n-dotierten InGaAs Sub-Kollektorschicht eine extrinsische InGaAs Sub-Kollektorschicht mit hohem Widerstand auszubilden (Isolationsimplantation). Diese ionenimplantierten Bereiche werden später zur Verbindung mit einer Emitterelektrode strukturiert, jedoch werden diese Bereiche nicht vollständig aus dem Bauelement entfernt. Die Implantation von Ionen in die Emitter- und in die Sub-Emitterschicht dient daher nicht zur späteren selektiven Entfernung, sondern lediglich zur Veränderung der charakteristischen Eigenschaften dieser Schichten.

US 2002/153534 A1 beschreibt eine Halbleiterstruktur mit drei nebeneinander angeordneten HBTs, die einen Emitter, eine Basis und einen Kollektor aufweisen. In die InAlAs Emitterschicht und in die InGaAs Sub-Emitterschicht werden Bor-Ionen (durch die Basisschicht) zur Ausbildung einer extrinsischer Emitter- und Sub-Emitterschicht implantiert (ebenfalls Isolationsimplantation). Auch hier werden diese Bereiche nicht vollständig aus dem Bauelement entfernt. Die Implantation von Ionen in Emitter- und Sub-Emitterschicht dient daher nicht zur späteren selektiven Entfernung, sondern lediglich zur Veränderung der charakteristischen Eigenschaften dieser Schichten.

US 2003/451122 A1 beschreibt die Schädigung von InGaP Emittermaterial durch Implantation von Ar-Ionen, um das geschädigte Gebiet später mittels HCl wegzuätzen, wobei ein Unterätzen einer Photolackschicht durch die Implantation der Ar-Ionen in das Emittermaterial verhindert oder minimiert werden soll.

Der Erfindung liegt die Aufgabe zugrunde, ein Verfahren anzugeben, mit dem eine von der Kristallorientierung des Wafers unabhängige dreidimensionale, materialselektive Strukturierung der Halbleitermaterialien Indiumgalliumarsenid und Indiumphosphid ermöglicht wird.

Die Aufgabe wird erfindungsgemäß gelöst durch die Merkmale des Anspruchs 1. Vorteilhafte Ausgestaltungen sind Gegenstand der Unteransprüche.

Danach wird eine Schichtfolge eines Kollektors aus Indiumphosphid, einer Basis aus Indiumgalliumarsenid und eines Emitters ausgebildet, nachfolgend ein den Emitter überdeckender Bereich maskiert. Ionen werden in den nicht maskierten Bereich der Basis und in den nicht maskierten Bereich des Kollektors zur Ausbildung eines geschädigten Bereichs implantiert, eine Basis-Metallisierung wird aufgebracht, wobei vor dem Aufbringen der Basis-Metallisierung der nicht von der Basismetallisierung zu bedeckende Bereich der Basis mittels einer Fotomaske abgedeckt wird, und wobei die Basis-Metallisierung sowohl einen Teil des geschädigten Bereichs als auch einen Teil des nicht geschädigten Bereichs überdeckt. Nachfolgend wird ein den Emitter überdeckender Bereich maskiert und der gesamte geschädigte Bereich der Basis und des Kollektors durch nasschemisches Ätzen entfernt.

Gegenüber den bisher üblichen nasschemischen Ätzverfahren ermöglicht das erfindungsgemäße Verfahren durch die jetzt mögliche dreidimensionale Strukturierung von Halbleitergebieten eine gezielte Optimierung von Halbleiterstrukturen. In der Technologie von Heterostruktur-Bipolartransistoren (HBTs) können nunmehr durch eine präzise laterale und vertikale Strukturierung von Halbleiterbereichen parasitäre, das heißt die Funktion des Bauelements negativ beeinflussende Halbleitergebiete gezielt entfernt und somit die Hochfrequenzeigenschaften dieser Bauelemente drastisch verbessert werden. Kompromisse hinsichtlich der Ausrichtung von Strukturen, z.B. der Stege, sind nicht mehr nötig, da nunmehr große Freiheitsgrade beim Design erreicht werden.

Durch die Ionenimplantation wird das Kristallgefüge der Halbleiter Indiumgalliumarsenid und Indiumphosphid in räumlich präzise definierbaren dreidimensionalen Gebieten so modifiziert, dass in einem folgenden nasschemischen Ätzschritt im wesentlichen nur diese Gebiete angegriffen werden.

Dabei erfolgt durch die Implantation mit Ionen definierter Energie in ausreichender Dosis eine Schädigung des Gitteraufbaus, teilweise sogar eine Amorphisierung. Diese quasi amorphisierten Bereiche zeichnen sich beim Nassätzen mit geeigneten Ätzmedien durch hohe Ätzselektivitäten gegenüber den nicht implantierten Materialien aus.

Der Effekt ist an sich bekannt und wurde bisher allein für die Herstellung von mikromechanischen Strukturen ausgenutzt, siehe Würfl et al., Deep Implantation of Nitrogen into GaAs for Selective Tree-dimensional Microstructuring, J. Appl. Phys. 72(7), 1. October 1992, S. 2700 bis 2704. Bei mikromechanischen Strukturen besteht für bestimmte Bauelemente u.a. die Forderung, gewisse Bereiche des Bauelements thermisch von einer Basis zu entkoppeln, was man mit einer lateralen Unterätzung erreicht, mit der ein solcher Bereich freigelegt wird, der dann nur noch über schmale Stege mit dem Basismaterial verbunden bleibt.

Das Verfahren erlaubt durch die Verwendung geeigneter Ätzmittel ein selektives Entfernen der ionenimplantierten Bereiche und damit die gezielte Bildung von Strukturen nicht nur in vertikaler, sondern auch in lateraler Richtung. Bereiche, die wegen ihrer hohen Dielektrizitätskonstante stören, können gezielt entfernt werden.

Die Erfindung soll nachfolgend an einem Ausführungsbeispiel eines InP-basierten HBTs näher erläutert werden. Es zeigen
- Fig. 1: ein Schema für das laterale Ätzverhalten in Abhängigkeit von der Kristallorientierung eines Wafers,
- Fig. 2: die erfindungsgemäßen Schritte zur Herstellung eines HBT,
- Fig. 3: einen erfindungsgemäß hergestellten HBT mit einem separaten Basisanschluss in einer Draufsicht,
- Fig. 4: den HBT nach Fig. 3 in einem Schnitt A-A' und
- Fig. 5: den HBT nach Fig. 3 in einem Schnitt B-B'.

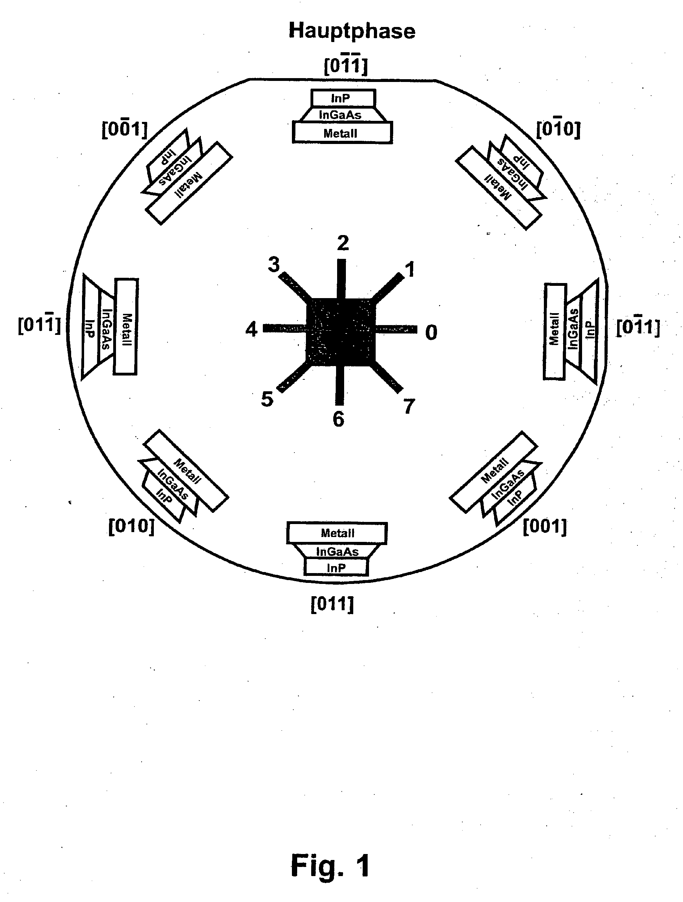

Fig. 1 zeigt das Problem beim nasschemischen Ätzen anhand eines Schemas für das anisotrope Ätzverhalten von InGaAs-und InP-Schichten auf einem Wafer.

InGaAs zeigt an den Seiten senkrecht zur Hauptphase (Testfingerrichtungen 2 und 6) eine negativ, in allen anderen Richtungen eine positiv verlaufende Flanke. InP zeigt in der Kristallrichtung [0-11], nämlich parallel zur Hauptphase (Testfingerrichtungen 0 und 4), eine positiv verlaufende Flanke, in Kristallrichtung [001], das heißt senkrecht zur Hauptphase (Testfingerrichtungen 2 und 6) eine negativ verlaufende Flanke und in den Kristallrichtungen [001], [010], [00-1], [0-10], nämlich 45° zur Hauptphase (Testfingerrichtungen 7, 5, 3, 1) verschiedene, parallelogrammförmig verlaufende Flanken, die in gegenüberliegenden Richtungen spiegelsymmetrisch sind.

Auch die Ätzgeschwindigkeit, bezogen auf das weggeätzte Volumen, ist von der Kristallorientierung abhängig.

Ein kontrolliertes Herstellen einer gewollten dreidimensionalen Form des Schichtaufbaus ist somit nicht möglich.

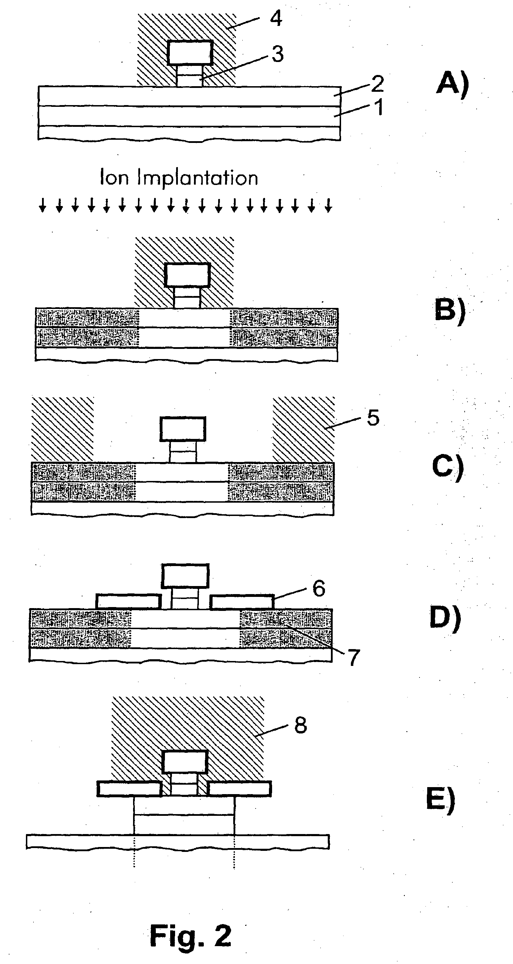

Fig. 2 zeigt dagegen die Schritte A bis E zur Herstellung einer Basis-Mesa eines Bipolartransistors nach der Erfindung. Ein 4-Zoll-Wafer, auf dem der Aufbau der Transistoren beispielsweise erfolgt, hat die Schichtfolge InP-Kollektor 1, InGaAs-Basis 2 und einen Emitter 3, die durch übliche Verfahren (CVD - chemical vapor deposition, MBE - molecular beam epitaxie) hergestellt sind.

Zur Vorbereitung der späteren präzisen Strukturierung von parasitären Halbleitergebieten eines InP-Kollektors 1 und einer InGaAs-Basis 2 wird zunächst ein Implantationsschritt mit Ar⁺-Ionen durchgeführt. Damit werden der InGaAs-Basis 2 und der InP-Kollektor 1 kontrolliert sowohl in der Breite als auch in der Tiefe geschädigt. Die lateralen Abmessungen werden zuvor durch eine Standard-Fotomaske 4 definiert (Schritt A), die Tiefe des implantierten Gebiets (Schritt B) ist durch die Energieverteilung der Ionen bestimmt. Vor der Basis-Metallisierung wird der entsprechende Bereich mit einer Fotomaske 5 abgedeckt (Schritt C). Anschließend wird die Basis-Metallisierung aufgebracht (Schritt D). Das Basis-Metall 6 überlappt die implantierten Bereiche 7 in der Form, dass trotz der infolge der Ionenimplantation gestörten Kristallbereiche ein zuverlässiger ohmscher Kontakt zur Basisschicht gewährleistet ist.

Nach einer weiteren Maskierung mit einer Fotomaske 8 wird das implantierte Basismaterial InGaAs durch verdünnte Kalilauge oder handelsüblichen Entwickler für Fotolacke (AZ 400K) selektiv zur nicht implantierten InGaAs-Schicht und dem InP entfernt (Schritt E). Der InP-Kollektor 1 wird durch die Mischung von Phosphorsäure und Wasser (H₃PO₄ : H₂O) selektiv zur nicht implantierten InP- und der InGaAs-Subkollektorschicht entfernt. Die Ätzrate ist über die Temperatur kontrollierbar.

Die weiteren Schritte zur Herstellung der HBTs entsprechen dem Standardprozess.

Durch die präzise laterale Unterätzung der Basis-Metallisierung wird die parasitäre Basis-Kollektor-Kapazität gesenkt, die aufgrund der hohen Dielektrizitätskonstante von InP sehr groß ist und damit die Hochfrequenzeigenschaften des Transistors begrenzt.

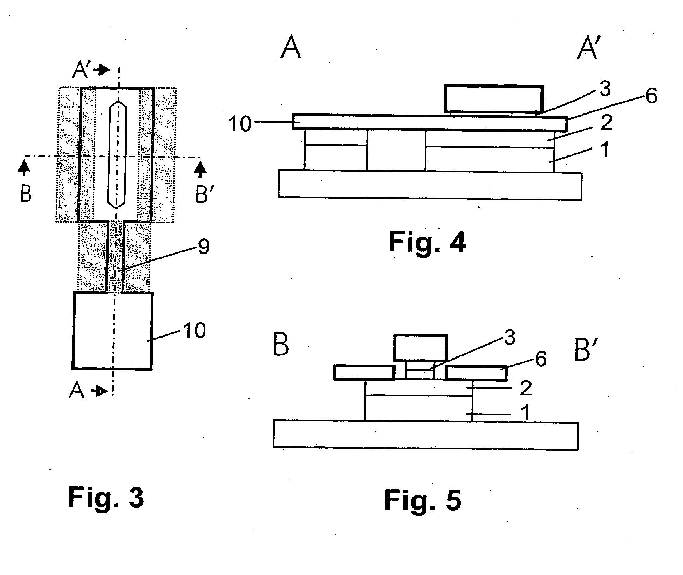

Die Fig. 3 bis 5 zeigen ein Beispiel für eine gezielte dreidimensionale Strukturierung von Halbleitergebieten von InP-basierten Heterojunction Bipolartransistoren durch Anwendung der erfindungsgemäßen Verfahrens. Mit der Strukturierung wird neben der oben beschriebenen Unterätzung der Basismetallisierung wird eine Brücke 9 zu einem Basisanschluss 10 geschaffen. Durch die Brückenbildung wird eine kapazitätsarme Leiterbahn hergestellt. Gegenüber bisherigen Methoden kann die Breite der Leiterbahn erhöht werden, da unabhängig von der Kristallorientierung eine sichere Unterätzung aus der breiteren Leiterbahn erzielt wird. Neben der Kapazität wird so auch die Induktivität der Leiterbahn gesenkt. Außerdem ist es möglich, die Leiterbahn zu verkürzen, was zu einem geringeren ohmschen Widerstand führt.

In beiden Fällen führt das Verfahren deshalb zu deutlich verbesserten Hochfrequenzeigenschaften und zu größerer Designfreiheit beim Entwurf der Transistorzellen. So kann beispielsweise durch ein günstigeres Layout ein Flächengewinn erzielt werden.

### Bezugszeichen

- 1: InP-Kollektor
- 2: InGaAs-Basis
- 3: Emitter
- 4: Standard-Fotomaske
- 5: Fotomaske
- 6: Basis-Metall
- 7: Implantierter Bereich
- 8: Fotomaske
- 9: Brücke
- 10: Basisanschluss

## Patentansprüche

1. Verfahren zur Herstellung eines InP-basierten Heterostruktur-Bipolartransistors mit folgenden Verfahrenschritten:
(a) Ausbilden einer Schichtfolge eines Kollektors (1) aus Indiumphosphid, einer Basis (2) aus Indiumgalliumarsenid und eines Emitters (3),
(b) nachfolgende Maskierung eines den Emitter (3) überdeckenden Bereiches und Implantation von Ionen in den nicht maskierten Bereich der Basis (2) und in den nicht maskierten Bereich des Kollektors (1) zur Ausbildung eines geschädigten Bereichs (7) der Basis (2) und des Kollektors (1),
(c) Aufbringen einer Basis-Metallisierung (6), wobei vor dem Aufbringen der Basis-Metallisierung (6) der nicht von der Basismetallisierung (6) zu bedeckende Bereich der Basis (2) mittels einer Fotomaske (5) abgedeckt wird, und wobei die Basis-Metallisierung (6) sowohl einen Teil des geschädigten Bereichs (7) als auch einen Teil des nicht geschädigten Bereichs überdeckt,
(d) nachfolgende Maskierung des Emitters (3) mittels einer Fotomaske (8), und
(e) Entfernen des gesamten geschädigten Bereichs (7) der Basis (2) und des Kollektors (1) durch nasschemisches Ätzen.

2. Verfahren nach Anspruch 1, **dadurch gekennzeichnet, dass** die Ionenimplantation mit Edelgasionen erfolgt.

3. Verfahren nach Anspruch 1, **dadurch gekennzeichnet, dass** der geschädigte Bereich (7) des Kollektors (1) mittels einer Mischung von Phosphorsäure und Wasser selektiv entfernt wird.

4. Verfahren nach Anspruch 1, **dadurch gekennzeichnet, dass** der geschädigte Bereich (7) der Basis (2) mittels verdünnter Kalilauge oder mittels eines Entwicklers für Fotolacke selektiv entfernt wird.

## Claims

1. Method for manufacturing an InP-based heterostructure bipolar transistor, comprising the following method steps:
(a) forming a layer sequence of a collector (1) made of indium phosphide, a base (2) made of indium gallium arsenide and an emitter (3),
(b) subsequent masking of a region covering the emitter (3) and implantation of ions into the unmasked region of the base (2) and into the unmasked region of the collector (1) to form a damaged region (7) of the base (2) and of the collector (1),
(c) applying a base metallization (6), wherein, before applying the base metallization (6), the region of the base (2) not to be covered by the base metallization (6) is covered using a photomask (5), and wherein the base metallization (6) covers both a part of the damaged region (7) and a part of the undamaged region,
(d) subsequent masking of the emitter (3) using a photomask (8), and
(e) removing the whole damaged region (7) of the base (2) and of the collector (1) by wet chemical etching.

2. Method according to claim 1, **characterized in that** the ion implantation is performed with noble gas ions.

3. Method according to claim 1, **characterized in that** the damaged region (7) of the collector (1) is selectively removed using a mixture of phosphoric acid and water.

4. Method according to claim 1, **characterized in that** the damaged region (7) of the base (2) is selectively removed using dilute potassium hydroxide solution or using a developer for photoresists.

## Revendications

1. Méthode de fabrication d'un transistor bipolaire à hétérostructure InP, comprenant les étapes de méthode suivantes :
(a) former une séquence de couches d'un collecteur (1) de phosphure d'indium, d'une base (2) d'indium-gallium-arséniure, et d'un émetteur (3),
(b) subséquemment masquer une région couvrant l'émetteur (3) et implanter des ions dans la région non masquée de la base (2) et dans la région non masquée du collecteur (1) pour former une région endommagée (7) de la base (2) et du collecteur (1),
(c) appliquer une métallisation de base (6), la région de la base (2) qui n'est pas à recouvrir par la métallisation de base (6) étant recouverte au moyen d'un masque photographique (5), avant l'application de la métallisation de base (6), et la métallisation de base (6) recouvrant et une partie de la région endommagée (7) et une partie de la région non endommagée,
(d) subséquemment masquer l'émetteur (3) au moyen d'un masque photographique (8), et
(e) enlever toute la région endommagée (7) de la base (2) et du collecteur (1) par gravure chimique humide.

2. Méthode selon la revendication 1, **caractérisée en ce que** l'implantation ionique a lieu avec des ions de gaz rare,

3. Méthode selon la revendication 1, **caractérisée en ce que** la région endommagée (7) du collecteur (1) est sélectivement enlevée par une mixture d'acide phosphorique et d'eau.

4. Méthode selon la revendication 1, **caractérisée en ce que** la région endommagée (7) de la base (2) est sélectivement enlevée par de l'hydroxyde de potassium dilué ou par un développeur de photorésines.
